## Europäisches Patentamt

## European Patent Office

## Office européen des brevets

(19)

(11) Veröffentlichungsnummer: **0 038 447 B1**

(12) **EUROPÄISCHE PATENTSCHRIFT**

(45) Veröffentlichungstag der Patentschrift: 24.07.85

(51) Int. Cl.⁴: **C 25 D 5/02, C 25 D 5/08**

(21) Anmeldenummer: **81102471.0**

(22) Anmeldetag: **01.04.81**

(54) **Vorrichtung zum partiellen Galvanisieren von leitenden oder leitend gemachten Oberflächen.**

(30) Priorität: **21.04.80 DE 3015282**

(43) Veröffentlichungstag der Anmeldung: **28.10.81 Patentblatt 81/43**

(45) Bekanntmachung des Hinweises auf die Patenterteilung: **24.07.85 Patentblatt 85/30**

(84) Benannte Vertragsstaaten: **BE GB NL**

(56) Entgegenhaltungen:
**CH - A - 610 356**
**DE - A - 2 705 158**
**DE - A - 2 733 720**
**DE - B - 2 620 995**

(73) Patentinhaber: **Siemens Aktiengesellschaft, Berlin und München Wittelsbacherplatz 2, D-8000 München 2 (DE)**

(72) Erfinder: **Hellwig, Hubertus, Dipl.-Ing., Weltistrasse 26, D-8000 München 71 (DE)**
Erfinder: **Schuster, Hans-Joachim, Dr., Max-Eyth-Strasse 9, D-1000 Berlin 33 (DE)**
Erfinder: **Heppner, Klaus-Dieter, Wilhelmsruher Damm 125, D-1000 Berlin 26 (DE)**

## Beschreibung

Die Erfindung betrifft eine Vorrichtung zum partiellen Galvanisieren von leitenden oder leitend gemachten Oberflächen nach dem Oberbegriff des Anspruchs 1.

Für das partielle Galvanisieren werden meist komplizierte und aufwendige Vorrichtungen benötigt, deren Einsatz aus wirtschaftlichen Gründen in der Regel nur bei Edelmetallen vertretbar ist. Damit der Galvanisiervorgang bei einer vorgegebenen Schichtdicke möglichst wenig Zeit beansprucht, werden hohe Strömungsgeschwindigkeiten des Elektrolyten und hohe Stromdichten angestrebt, denn nur auf diese Weise lassen sich hohe Abscheidegeschwindigkeiten erzielen.

Es sind zahlreiche Vorrichtungen zum partiellen Galvanisieren bekanntgeworden, deren Hauptmerkmal darin besteht, dass die Düsen senkrecht gegen die zu behandelnde Oberfläche gerichtet sind. Ferner ist es bekannt, dass die Düsen bzw. Teile derselben als Anode und die zu behandelnden Oberflächen als Kathoden geschaltet sind. Damit bei einer senkrechten Anordnung der Düsen der Elektrolyt abfliessen kann, müssen die Düsen in einem entsprechenden Abstand von der zu behandelnden Oberfläche angeordnet sein, d. h. der Elektrolyt verlässt die Düse als Freistrahl.

Aus der DE-B2-2 620 995 ist eine gattungsgemässe Vorrichtung bekannt, bei welcher die nicht zu galvanisierenden Oberflächenbereiche durch eine Maske abgedeckt werden, während als Zuströmquerschnitte für die Elektrolytlösung senkrecht gegen die zu galvanisierenden Bereiche gerichtete Düsen mit als Anoden geschalteten rohrförmigen Endteilen vorgesehen sind. Um die Ableitung der in senkrechter Richtung als Freistrahl zugeführten Elektrolytlösung zu erleichtern, sind die den Düsen zugewandten Öffnungen der Maske kegelstumpfförmig ausgebildet.

Durch die DE-A1-2 705 158 ist eine Vorrichtung zum partiellen Galvanisieren bekanntgeworden, bei welcher die Elektrolytlösung aus einer Düse in Form eines Haft- oder Wandstrahls auf die zu galvanisierenden Oberflächenbereiche aufgebracht wird, während die abströmende Elektrolytlösung über Fangdüsen abgesaugt wird. Dabei soll durch den als Freistrahl tangential an die zu galvanisierenden Oberflächenbereiche herangeführten Elektrolytstrahl eine funktionsgerechte Schichtdickenverteilung erzielt werden.

Schliesslich ist aus der US-A-3 933 615 eine Vorrichtung zum Ätzen und Galvanisieren von Schaltungsplatten bekannt, bei der zum gleichzeitigen Behandeln beider Seiten der Schaltungsplatte an jeder Seite derselben je eine Elektrolytkammer angeordnet ist, die auf der der Schaltungsplatte zugekehrten Seite einen sich über die Länge derselben erstreckenden Schlitz aufweist, aus dem der Elektrolyt im spitzen Winkel gegen die Schaltungsplatte austritt und entlang dieser nach unten abfliesst. Die aus Isoliermaterial bestehenden Elektrolytkammern liegen nicht direkt an der Schaltungsplatte an, sondern über Zwischenlagen aus Isolierstoff, deren Stärke so bemessen ist, dass die nach unten abfliessenden Elektrolytströme an den unmittelbar unter den Elektrolytkammern angeordneten Elektroden vorbeigeführt sind.

Hierbei schliesst die sich über die gesamte Schlitzbreite der Elektrolytkammer erstreckende Elektrode bündig mit der der Schaltungsplatte zugekehrten Seite der Elektrolytkammer ab. Auf diese Weise entsteht also eine Art Abflussspalt, der in einem Sumpf endet.

Wie bereits eingangs erwähnt, erfordert eine hohe Abscheidegeschwindigkeit beim Galvanisieren eine hohe Relativbewegung zwischen der zu beschichtenden Fläche und dem Elektrolyten, um eine Verarmung an Metallionen im Kathodenfilm zu verhindern. Man ist also bestrebt, eine möglichst hohe Strömungsgeschwindigkeit des Elektrolyten zu erhalten. Hohe Strömungsgeschwindigkeiten verursachen jedoch bei diesen Anordnungen, die senkrecht gegen die zu behandelnde Fläche gerichtet sind, stark turbulente Strömungen, die naturgemäss die Höhe der Strömungsgeschwindigkeiten wieder begrenzen.

Es hat sich ferner gezeigt, dass Vorrichtungen, bei denen solche turbulente Strömungen an der zu behandelnden Fläche auftreten, insbesondere zur Abscheidung von Metallen der Platingruppe nicht geeignet sind, weil die abgeschiedenen Schichten zur Rissbildung neigen.

Der Erfindung liegt die Aufgabe zugrunde, eine Vorrichtung zum partiellen Galvanisieren von leitenden oder leitend gemachten Oberflächen zu schaffen, mit der nicht nur sehr hohe Strömungsgeschwindigkeiten erzielbar sind, sondern mit der auch spröde, zur Rissbildung neigende Schichten von Metallen der Platingruppe wie Rhodium, Ruthenium und Palladium mit kurzen Expositionszeiten abgeschieden werden können.

Diese Aufgabe wird bei einer gattungsgemässen Vorrichtung durch die kennzeichnenden Merkmale des Anspruchs 1 gelöst.

Eine besonders einfache Anordnung der Anoden wird nach einer weiteren Ausbildung der Erfindung dadurch erreicht, dass der Anströmkanal und der Abströmkanal im Querschnitt kreisförmig sind und dass die Anode die Form eines Röhrchens oder Halbröhrchens besitzt.

Die mit der Erfindung erzielten Vorteile bestehen insbesondere darin, dass durch eine definierte Elektrolytführung über in der Maske gebildete Anströmkanäle und Abströmkanäle mit einer Umlenkung des Elektrolytstroms von weniger als 90° an der zu behandelnden Oberfläche eine annähernd laminare Strömung mit allenfalls geringen Turbulenzen erzielt werden kann. Dadurch kann die Strömungsgeschwindigkeit der Elektrolytlösung auch bei Metallen der Platingruppe sehr hoch gewählt werden. Es hat sich ferner gezeigt, dass bei einer annähernd laminaren Strömung an der zu behandelnden Fläche wesentlich höhere Stromdichten zulässig sind als bei turbulenten Strömungen, so dass sich damit erheblich höhere Abscheidegeschwindigkeiten ohne Rissbildung der Schichten auch bei höheren Temperaturen erzielen lassen. Versuche haben ergeben, dass sogar eine Temperaturbeanspruchung von z. B. 350° zulässig ist, ohne dass eine Rissbildung der Schichten auftritt.

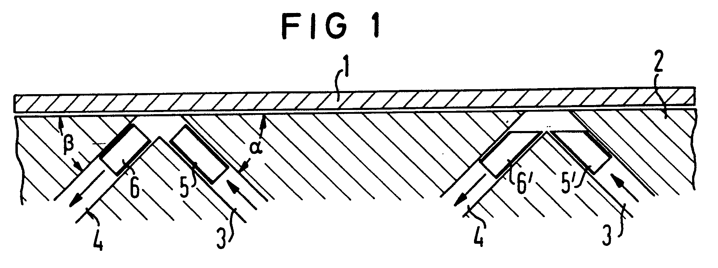

Ein Ausführungsbeispiel der Erfindung ist in der Zeichnung dargestellt und wird im folgenden näher beschrieben.

Die Zeichnung zeigt – nicht massstabsgerecht – eine Vorrichtung zum partiellen Galvanisieren mit im Winkel angeordneter Elektrolytzu- und -abführung. Dabei ist mit 1 eine Platte bezeichnet, welche an zwei Stellen der Oberfläche partiell galvanisiert werden soll. In einer Abdeckung bzw. Maske 2, welche aus korrosionsbeständigem Material wie z. B. Polytetrafluoräthylen besteht, sind Kanäle für die Elektrolytzu- und -abführung gebildet. Mit 3 ist ein Anströmkanal bezeichnet, dessen Anströmwinkel $\alpha$ in bezug auf den zu galvanisierenden Oberflächenbereich kleiner als 45° ist. Mit 4 ist ein Abströmkanal bezeichnet, dessen Anströmwinkel $\beta$ in bezug auf den zu galvanisierenden Oberflächenbereich ebenfalls kleiner als 45° ist. Der Querschnitt des Abströmkanals 4 ist dabei mindestens gleich dem Querschnitt des Anströmkanals 3. Pfeile deuten die Flussrichtung des Elektrolyten an. Die Kanäle 3 und 4 können einen runden oder vieleckigen Querschnitt aufweisen, wobei sowohl in den Anströmkanal 3 als auch in dem Abströmkanal 4 eine die Form eines Röhrchens aufweisende Anode 5 bzw. 6 angeordnet ist, welche beispielsweise aus Platin besteht. Die zumindest an der Oberfläche elektrisch leitende Platte 1 ist hierbei als Kathode geschaltet. Der Anströmkanal 3 steht hierbei unmittelbar oder mittelbar über einen Verteiler mit einer Umwälzpumpe in Verbindung, was in der Zeichnung nicht dargestellt ist.

Wie aus dem rechten Teil der Zeichnung zu ersehen ist, können die Anoden 5′ und 6′ so ausgebildet sein, dass eine bestimmte Schichtdickenverteilung zustandekommt. Bei dem dargestellten Ausführungsbeispiel sind die die Form eines Röhrchens aufweisenden Anoden 5′ und 6′ parallel zur Platte 1 abgeschrägt.

**Patentansprüche**

1. Vorrichtung zum partiellen Galvanisieren von leitenden oder leitend gemachten Oberflächen durch Abscheidung von Metallen oder deren Legierungen aus Elektrolytlösungen, mit
– einer Maske (2) aus korrosionsbeständigem Material zur Abdeckung der nicht zu galvanisierenden Oberflächenbereiche,
– einem auf die zu galvanisierenden Oberflächenbereiche gerichteten Zuströmquerschnitt für die Elektrolytlösung,
– einer die Elektrolytlösung berührenden Anode (5, 6; 5′, 6′) und mit
– einer im Winkel angeordneten Elektrolytzu- und -abführung,
gekennzeichnet durch folgende Merkmale:
a) als Zuströmquerschnitt für die Elektrolytlösung ist in der Maske (2) mindestens ein Anströmkanal (3) gebildet, dessen Anströmwinkel ($\alpha$) in

bezug auf den zu galvanisierenden Oberflächenbereich kleiner als 45° ist,
b) als Abströmquerschnitt für die Elektrolytlösung ist in der Maske (2) mindestens ein Abströmkanal (4) gebildet, dessen Abströmwinkel ($\beta$) in bezug auf den zu galvanisierenden Oberflächenbereich kleiner als 45° ist,
c) die Anode (5, 6; 5′, 6′) ist in dem Anströmkanal (3) und/oder in dem Abströmkanal (4) der Maske (2) angeordnet.

2. Vorrichtung nach Anspruch 1, dadurch gekennzeichnet, dass der Anströmkanal (3) und der Abströmkanal (4) im Querschnitt kreisförmig sind und dass die Anode (5, 6) die Form eines Röhrchens oder Halbröhrchens besitzt.

**Claims**

1. Apparatus for the partial electroplating of conductive surfaces, or surfaces which have been rendered conductive, by the deposition of metals or alloys thereof from electrolyte solutions, comprising
– a mask (2) made of corrosion-resistant material which serves to cover those areas of the surface which are not to be electroplated;
– an inflow cross-section for the electrolyte solution which is directed towards those areas of the surface which are to be electroplated;
– an anode (5, 6; 5′, 6′) which is in contact with the electrolyte solution; and
– an angled electrolyte supply and discharge line, characterised by the following features:
a) as the inflow cross-section for the electrolyte solution, there is formed in the mask (2) at least one inflow channel (3) whose inflow angle ($\alpha$) relative to the area of the surface which is to be electroplated is less than 45°;
b) as outflow cross-section for the electrolyte solution, there is formed in the mask (2) at least one outflow channel (4) whose outflow angle ($\beta$) relative to the area of the surface which is to be electroplated is less than 45°;
c) the anode (5, 6; 5′, 6′) is arranged in the inflow channel (3) and/or in the outflow channel (4) of the mask (2).

2. Apparatus as claimed in Claim 1, characterised in that the inflow channel (3) and the outflow channel (4) are circular in cross-section and that the anode (5, 6) has the form of a small tube or half-tube.

**Revendications**

1. Dispositif de revêtement partiel par voie électrolytique de surfaces conductrices ou rendues conductrices par dépôt de métaux ou de leurs alliages à partir de solutions d'électrolyte, comprenant:
– un masque (2) en matériau résistant à la corrosion pour recouvrir les régions de surfaces qui ne sont pas à revêtir par voie électrolytique;
– une section transversale d'arrivée du courant de la solution d'électrolyte dirigée sur les ré-

gîons de surfaces à revêtir par voie électrolytique;
- une anode (5, 6; 5′, 6′) en contact avec la solution d'électrolyte; et
- une arrivée et une évacuation d'électrolyte disposées suivant un angle,

remarquable par les caractéristiques suivantes:

a) comme section transversale d'arrivée du courant de la solution d'électrolyte il est formé dans le masque (2) au moins un canal d'arrivée (3) dont l'angle d'incidence (α) par rapport à la région de surfaces à revêtir par voie électrolytique est inférieur à 45°;

b) comme section transversale d'évacuation pour la solution d'électrolyte il est ménagé dans le masque (2) au moins un canal d'évacuation (4) dont l'angle de sortie (β) par rapport à la région de surfaces à revêtir par voie électrolytique est inférieur à 45°;

c) l'anode (5, 6; 5′, 6′) est disposée dans le canal d'arrivée (3) et/ou dans le canal d'évacuation (4) du masque (2).

2. Dispositif selon la revendication 1, caractérisé en ce que le canal d'arrivée (3) et le canal d'évacuation (4) ont une section transversale circulaire et en ce que l'anode (5, 6) a la forme d'un petit tube ou de la moitié d'un petit tube.

# FIG 1